(19) Europäisches Patentamt

European Patent Office

Office européen des brevets

(11) **EP 1 333 679 B1**

(12) **EUROPEAN PATENT SPECIFICATION**

(45) Date of publication and mention
of the grant of the patent:
**14.04.2004 Bulletin 2004/16**

(51) Int Cl.[7]: **H04N 7/26**, H03M 7/40,
H03M 7/46, H04N 7/30

(21) Application number: **02002641.5**

(22) Date of filing: **05.02.2002**

(54) **Data compression**

Datenkompression

Compression de données

(84) Designated Contracting States:
**AT BE CH CY DE DK ES FI FR GB GR IE IT LI LU
MC NL PT SE TR**
Designated Extension States:
**AL LT LV MK RO SI**

(43) Date of publication of application:
**06.08.2003 Bulletin 2003/32**

(73) Proprietor: **SIEMENS AKTIENGESELLSCHAFT
80333 München (DE)**

(72) Inventor: **Illgner, Klaus, Dr.
81549 München (DE)**

(56) References cited:
**EP-A- 0 940 994     EP-A- 1 047 271**

- **ORDENTLICH E ET AL: "A low-complexity
  modeling approach for embedded coding of
  wavelet coefficients" DATA COMPRESSION
  CONFERENCE, 1998. DCC '98. PROCEEDINGS
  SNOWBIRD, UT, USA 30 MARCH-1 APRIL 1998,
  LOS ALAMITOS, CA, USA,IEEE COMPUT. SOC,
  US, 30 March 1998 (1998-03-30), pages 408-417,
  XP010276632 ISBN: 0-8186-8406-2**
- **SHEUNG-YEUNG WANG ET AL: "Successive
  partition zero coder for embedded lossless
  wavelet-based image coding" IMAGE
  PROCESSING, 1999. ICIP 99. PROCEEDINGS.
  1999 INTERNATIONAL CONFERENCE ON
  KOBE, JAPAN 24-28 OCT. 1999, PISCATAWAY,
  NJ, USA,IEEE, US, 24 October 1999 (1999-10-24),
  pages 40-43, XP010368655 ISBN: 0-7803-5467-2**

Note: Within nine months from the publication of the mention of the grant of the European patent, any person may give
notice to the European Patent Office of opposition to the European patent granted. Notice of opposition shall be filed in
a written reasoned statement. It shall not be deemed to have been filed until the opposition fee has been paid. (Art.
99(1) European Patent Convention).

**Description**

Field of the invention

The present invention relates to a method of data compression and, in particular, but not restricted thereto, to a method of quantizing and entropy encoding transform coefficients in the encoding of multimedia data.

Background to the invention

Video coding systems are presently being developed for a diverse range of technologies including cable television, video conferencing and interactive services for mobile video handsets. As the capacity of communications networks to transfer large amounts of data increases, access to interactive video/audio systems has become increasingly common. Systems and standards capable of supporting such increasing data transfer needs are also being developed.

The Moving Picture Experts Group (MPEG) is a working group of researchers and developers who work in conjunction with the International Standards Organisation (ISO/IEC) in the development of standards for coded representation of digital audio and video. Other standards bodies are involved with the development of digital audio and video standards, a further example being ITU. To date these standards bodies are responsible for the creation and implementation of several audio and video standards including compression algorithms, processing schemes and authoring environments.

MPEG has produced: the MPEG-1 standard for storage and retrieval of moving pictures and audio; the MPEG-2 standard for digital television; and, more recently, the MPEG-4 standard for multimedia applications. MPEG are currently developing MPEG-7, a content representation standard for multimedia content description interfaces.

MPEG-4 provides an object-based coding standard which gives flexibility to authors, service providers and end users of highly interactive, multimedia content. Whilst natural audio and video content (recorded audio and video) is still addressed by MPEG-4, the standard now also addresses the coded representation of synthetic (computer generated) audio and visual objects (AVOs). MPEG-4 was developed to provide the necessary facilities for specifying how AVOs, both natural and synthetic, can be composed together in space and time whilst allowing for interactive delivery. A further focus in the development of the MPEG-4 standard was the performance of coding and transmission of such content within a variety of different scenarios. The standard was consequently designed to accommodate "universal access" to multimedia information by taking into account possible bandwidth-specific problems presented by a wide variety of network situations.

Individual object streaming is another development within MPEG-4. Within any given MPEG-4 scene, a series of video objects may be streamed individually to an end user's computer. Each of these individual streams can be time-stamped to enable synchronisation. Since the individual elements being streamed are independent of one another, they can easily be dropped or added in accordance with the interactive needs of the scene and the user's involvement with that scene.

The presence of multiple streams engenders the need for information regarding the network itself: for example, the synchronisation of an entire scene could be jeopardised if congestion occurs. To circumvent potential congestion problems, MPEG-4 has included a set of descriptors within each of the streams which provide information relating to the required decoding software, necessary timing information and required quality of service (QoS) requirements for the scene to be successfully streamed. Consequently, MPEG-4 is arranged to be capable of flexible delivery of multimedia content over a variety of operational environments and network situations. MPEG-4 is also arranged to have the ability to provide information as to the complexity of the scenes being transmitted, the QoS required to transmit such scenes and the synchronisation of the elements within the scene.

An important feature of data storage and transfer is the degree of compression of the data. Data compression reduces the bandwidth required to transmit and store data. Compression is a reversible operation, which converts data from an initial uncompressed data format to a compressed format that requires fewer bits. Data which has been compressed can be stored or transmitted more efficiently. When required, the operation can be reversed and the original uncompressed data can be reproduced. Reproduction or reconstruction of the original data can be classed as either lossless or lossy. In a lossy compression system, the source data cannot be reconstructed perfectly: in a lossless system, it can be. Clearly, lossless compression is most suitable where perfect reconstruction is desirable, for instance the compression of text data or in the compression of medical or artistic images. By contrast, a certain degree of information loss may well be tolerable, as for example in the compression of most still image, audio or video data.

A compression operation can be considered as having two component stages. The first stage comprises an encoder model stage in which redundancy and other irrelevant detail is minimised. The second stage comprises an entropy encoding stage in which statistical properties are exploited to generate a very much reduced set of symbols which represent the information distilled from the original uncompressed data and in which the symbols themselves are entropy encoded for the greatest encoding efficiency.

By careful choice of code, the statistical properties of the symbols, for instance the distribution of zero's and one's in the binary representation of the symbols, can be used to further compress the information of the original data. Runs of zero's can be encoded efficiently by transmitting a number representing the length of the current run rather than the zero values themselves. This technique is known as run-length coding (RLC).

RLC is often used as a pre-coding technique to prepare the data for a technique which exploits the frequency of occurrence of certain symbols. Variable length coding (VLC) encodes non-zero coefficients by representing the more frequently occurring symbols with short codes (codes having shorter bitlengths) and less frequently occurring symbols with longer codes. VLCs are not necessarily static and if the data being represented changes in its frequency characteristics the VLC technique can be arranged to allow for the assignment of codes to symbols to be adapted accordingly. The current set of assignments are stored in a VLC table.

VLC can be illustrated by analogy to the encoding of text for transmission along a telegraph wire using Morse code. When encoding substantial passages of text in the English language, a frequency distribution pattern will emerge. Certain letters are observed to occur very frequently, for example E, T, A, O and N, and certain other letters comparatively infrequently, for example Q and Z. So that telegraph operators took less time to transmit messages, Morse code assigns its shortest codes to more frequently occurring letters and considerably longer codes to the rarer letters. Morse code is an example of a static VLC.

As an entropy encoding technique, variable length coding (VLC) has advantages and disadvantages. VLC tables are easy to construct offline, for example by the Huffman algorithm. Encoding using VLC tables is very simple since encoding simply comprises the indexing of a large table with an entry for each possible symbol. Decoding is a bit more complex as it requires the bitstream to be parsed and the identification of variable length code words. If memory is not a constraint, decoding can also be realised as a look-up table.

VLC tables do however require memory for storage. Symbol statistics, the probabilities of the occurrences of input symbols, vary between sequences of symbols. In the Morse code analogy, the language being represented may be different, say Polish rather than English, or the type of information being represented may change, for instance stock market data rather than business letters. A single table can reflect only a more or less well-matching average and will thus limit the compression efficiency. Employing several tables for different symbol statistics becomes infeasible as this requires a significant amount of memory for storing all the tables, regardless of the encoding (or decoding) approach. The underlying statistics of the VLC tables must therefore be calculated or measured online to adapt to the statistical changes measured between sequences symbols, in a process known as adaptive VLC. The calculation or measurement increases not only the computational load in that a complete new code table must be generate each time but also carries the risk that encoder/decoder mismatches will occur in the event of transmission errors. The potential for mismatches explains why this approach is not more widely utilised.

In VLC tables, at least one bit is invariably assigned to the most probable code word. This assignment in itself constitutes a significant source of redundancy. Encoding more than one symbol simultaneously would improve the performance but at the same time would increase VLC table size considerably.

An alternative approach to entropy encoding uses context-based arithmetic coding. Arithmetic coding has become a standard entropy encoding technique and is now included as an option in ITU-T Recommendation H.263.

Arithmetic coding is a method of encoding data using a variable number of bits. The number of bits used to encode each symbol varies according to the probability assigned to that symbol. Low probability symbols use many bits, high probability symbols use fewer bits. Unlike Huffman coding, however, arithmetic encoders do not have to use an integral number of bits to encode each symbol. If the optimal number of bits for a symbol is 2.4, a Huffman coder will probably use 2 bits per symbol, whereas the arithmetic encoder may use very close to 2.4.

In arithmetic coding, a sequence of symbols, $X_1, X_2, ... X_n$, is processed as a vector from left to right in order. The symbols are not replaced by a string of codebits but rather each symbol, $X_i$, is assigned a distinct subinterval, $I_i$, of the unit interval [0,1]. The subintervals are chosen so that $I_1 \supset I_2 \supset ... \supset I_n$ and so that $I_i$ is determined from the previously processed samples, $X_1, X_2, ... X_{n-1}$ in conjunction with the current sample $X_i$. Where the assignment of subintervals is altered in accordance with changes in the probabilities of symbols in the previously processed samples, the arithmetic coding is said to be adaptive. Once the final interval $I_n$ has been determined, a code word ($B_1, B_2, ... B_L$) is assigned to the entire sequence such that: the rational number $.B_1B_2...B_L$ given by: $.B_1B_2...B_L = B_1/2 + B_2/4 + ... + B_L/2^L$ is a point in interval $I_n$.

In summary, VLC (Huffman codes) and arithmetic coding yield the same performance from a theoretical point of view. Arithmetic coding however performs better in practical applications. The better performance stems from the fact that the minimal number of bits per symbol can be less than one in arithmetic coding. In effect, arithmetic coding combines the fractional bits of consecutive symbols. This means an arithmetic coder can usually encode a message using fewer bits than a Huffman coder.

Rather than having to generate a new tables for each new statistical distribution pattern, arithmetic coding can be self-adaptive to the incoming data stream.

Furthermore, no code tables need be stored in arithmetic coding. In considering an alphabet of possible input symbols, only the probabilities of occurrences of each symbol of the alphabet must be known. Provided the alphabet remains small, no significant memory is needed. As will be demonstrated, this feature is exploited in context-based bitplane coding, where the alphabet is very small and for each context a different statistic is used.

The context selection is arranged to exploit statistical dependencies between neighbouring symbols, which in turn leads to an increase of the probability of one (or a limited number of) symbols. These increased probability symbols are then assigned very short theoretical code words (less than one bit per symbol when consecutive symbols are combined). For these symbols arithmetic coding can efficiently combine the fractional bits to give very short real code words.

Arithmetic coding does have some notable deficiencies: in particular a complexity which is high in comparison to entropy encoding using RLC/VLC. Furthermore, arithmetic codes are very sensitive to bit errors. Whilst VLC functions can be adapted to have automatic resynchronisation characteristics or at least to allow for the identification of decoding errors, arithmetic codes can not.

Other entropy encoding techniques are known. These techniques are not however enshrined in the current standards. Generally speaking they are based on scanning the bits of the incoming data stream in a predefined order prior to Huffman coding.

Proc. Data Compression Conf. 1998, Los Alamitos, CA, USA, 30 March - 1 April 1998, IEEE Computer Soc., pp. 408-417 discloses context selection based on bit-plane layered transform coefficients, wherein statistical dependencies between weighbouring pixels are exploited to generate selected context patterns. The generated bitstreams per bitplane are Golomb encoded.

The present invention seeks to provide an improved coding scheme. In particular, the present invention seeks to provide a coding scheme which has a reduced dependency upon large tables and to provide a simple and fast encoding and decoding mechanism. Further the present invention seeks to provide a coding scheme having a good capability to adjust to different signal statistics, the ability to recognise bit errors/decoding errors and the ability to assign less than one bit of data per symbol by exploiting statistical dependencies.

Statement of the invention

In accordance with one aspect of the present invention there is provided a method of encoding source data as defined in claim 1, comprising decorrelating source data to generate transform coefficient information; slicing said transform coefficient information into a plurality of bitplanes, said plurality of bitplanes including at least one least significant bitplane; context selecting from the bitplanes to generate a plurality of context levels; and for at least some of the plurality of context levels, applying run-length pre-coding to generate sequences of pre-coded symbols and then encoding said pre-coded symbol sequences by an analytical entropy coding scheme.

The analytical entropy coding scheme is a Golomb coding scheme.

The symbol sequences are preferably binary symbol sequences.

The bitplane slicing is advantageously performed by the Zero-tree approach.

In accordance with a further aspect of the present invention there is provided a data encoding apparatus as set out in claim 6.

The context selection stage preferably includes measuring the frequency of zeros or alternatively ones for each of a plurality of contexts, generating a probability model and comparing the measured frequency of zeros for each of the contexts with the probability model. A selected context is advantageously selected by establishing which of the available contexts best matches the probability model for which a Golomb Code of order m is optimal.

Brief description of the figures

The invention may be understood more readily, and various other aspects and features of the invention may become apparent, from consideration of the following description and the figures as shown in the following drawing sheets, wherein:

Figure 1 shows a block diagram of a source encoding process using variable length encoding;
Figure 2A shows a block diagram of a source encoding process as it is used for example in the MPEG-4 FGS profile
Figure 2B shows a block diagram of a modified source encoding process with context-selective adaptive arithmetic coding; and
Figure 3 shows a block diagram of source encoding process in accordance with the present invention.

Detailed description of the present invention

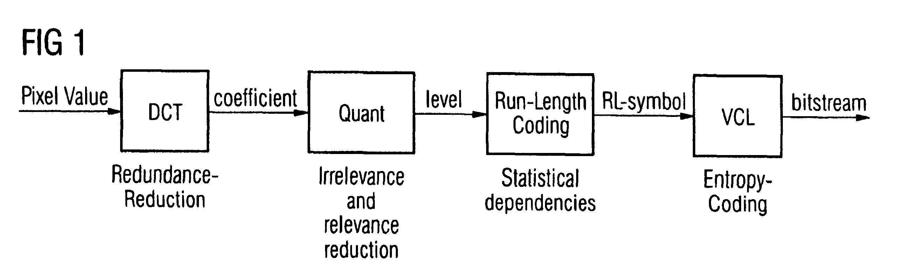

Figure 1 diagrammatically illustrates a flow diagram of the stages in one well-known data compression technique. The encoder model stage first reduces redundancy as much as possible. To this end, a redundance reduction function, for instance discrete cosine transform (DCT), is applied to the initial data. Redundance reduction is often referred to as decorrelation in the video coding literature since the transforms applied to the incoming data upset the spatial correlation between neighbouring pixels of the original image.

The redundancy reduction function outputs a reduced set of transform coefficients which still however contain a certain amount of subjectively irrelevant detail. The irrelevant data is then removed by the application of a quantization function. The removal of irrelevant data is irreversible and results in an overall loss of information.

The loss of information is represented schematically in Figure 1 by the introduction of a feature known as a quantizer. Quantizers, as the name suggests, have the effect of "rounding off" values - in effect reducing the number of symbols used to represent original data values in comparison to the 'alphabet' of possible values taken by transform coefficients. Quantizers generate output as quantizer level symbols.

Statistical dependencies still exist between the quantizer levels. The subsequent entropy encoding stage seeks to exploit those statistical dependencies.

A run-length pre-coding function (RLC) is applied to the quantizer level symbols and by exploiting statistical dependencies between the level symbols further reduces the number of bits required to represent the original data. Essentially "runs" of the same quantizer level symbol are represented as (shorter) run-length symbols having a fixed bitlength.

The run-length symbols are further compacted by applying specifically designed variable length code tables, for example using Huffman coding. The unequal probabilities of the occurrences of each run-length symbol allows entropy coding by the assignment of the shortest VLC to the most frequently occurring run-length symbol.

The compression technique described above has numerous applications, including still image and video coding and notably including the well-known JPEG standard.

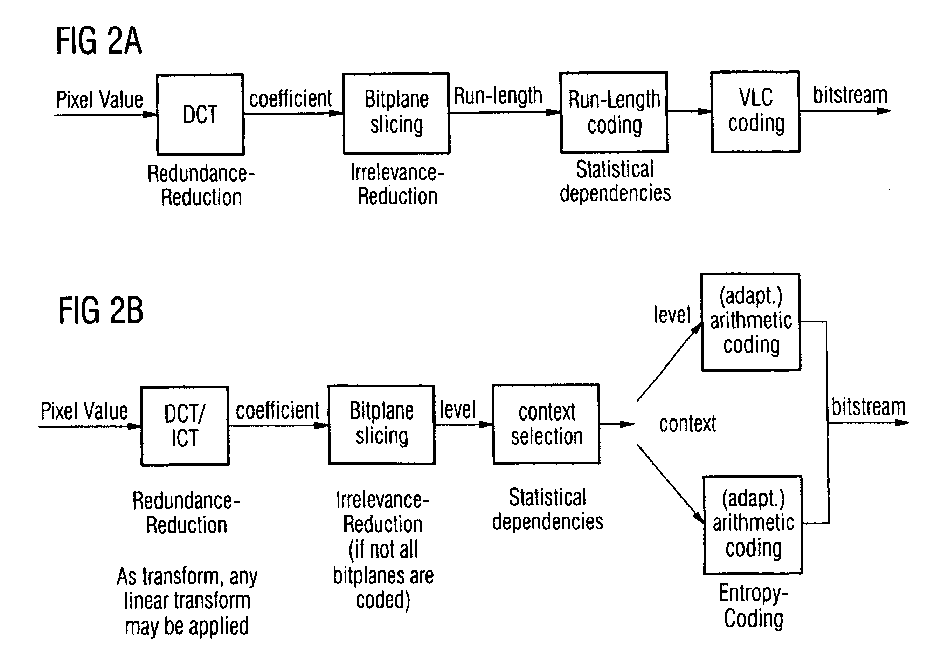

Another form of coding, which is presently included in the MPEG-4 FGS profile and in the forthcoming JPEG 2000 standard, takes the reduced transform coefficients from the output of a DCT function and applies first bit-plane coding, then pre-coding for runs of identical values, and finally assigns variable length codes according to the probability of the occurrence of the run length symbols. This form of coding can be seen as a specific embodiment of the scheme illustrated in Figure 1, the quantizer being a bit-plane slicer. As will be understood by the reader, the effect of discarding the least significant bit planes generated by a bit plane slicer is to round off the values of the transform coefficients and thereby reduce the number of symbols required to represent the data stream. A block diagram of the flow of the MPEG-4 FGS profile is shown in Figure 2A.

Figure 2B shows a flow diagram of the stages in another well-known data compression technique. Here the entropy coding is achieved using context-based arithmetic coding rather than the RLC/VLC scheme of Figure 2A. To that end, the quantizer known from Figure 1 is again replaced by a mechanism for slicing transform coefficients into bitplanes.

A key aspect for the subsequent arithmetic coding is to maintain a small symbol alphabet.

Statistical dependencies are then selected by a context selection means which provides multilevel context paths to the subsequent entropy encoding mechanism. The selection of a certain context tries to predict the current symbol from its neighbouring symbols. The high probability of the current symbol occurring in a specific context can then be utilised efficiently by a subsequent entropy encoding mechanism. In the case illustrated in Figure 2B the subsequent entropy encoding mechanism is an adaptive arithmetic coding mechanism.

Variants of bitplane slicing mechanisms exist, for example the Zero tree approach.

There will now be described, by way of example, the best mode contemplated by the inventors for carrying out the invention. In the following description, numerous specific details are set out in order to provide a complete understanding of the present invention. It will be apparent, however, to those skilled in the art, that the present invention may be put into practice with variations of the specific details.

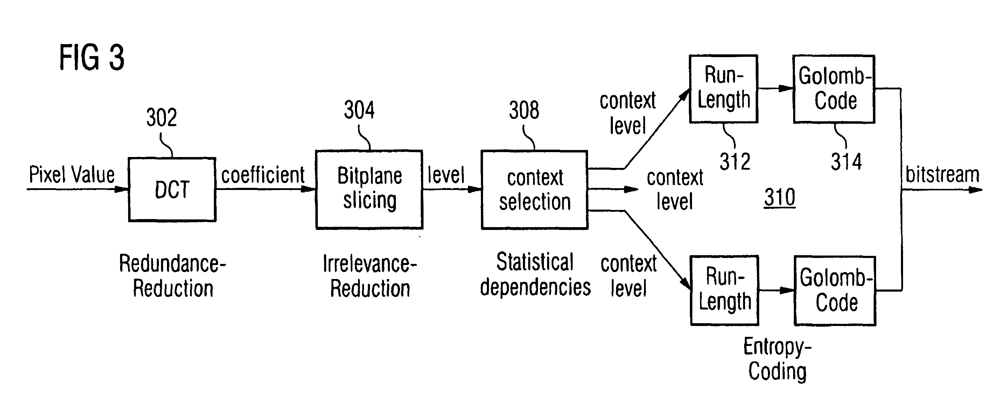

Referring now Figure 3, there is shown a block diagram of a process 300 for encoding image data in accordance with the present invention. As is known, pixel value data is input into a redundancy reduction processor 302: in Figure 3, the redundancy reduction processor is a DCT function. The redundancy reduction processor 302 generates reduced coefficients. An irrelevant data reduction processor 304 takes the reduced coefficients as input. The reduction of irrelevant data is conveniently performed by a bit plane slicer. From the irrelevant data reduction processor 304, statistical dependencies are selected in a context selection means 308 whereby to provide multilevel context paths in an entropy encoding mechanism 310.

By comparing Figures 2B and 3, one observes that the two encoding techniques differ in their entropy encoding mechanisms. In the inventive technique of Figure 3, a run-length pre-coder 312 receives input data at each context level. The run-length pre-coder 312 then outputs run-length symbols and passes the symbols to an analytical entropy coder 314. It should be noted that the context selection stage in Figure 2B differs fundamentally from that in Figure 3. Context selection in the present invention allows for progressive encoding and decoding.

To illustrate the distinction, consider a 2D arrangement of samples having the following appearance:

X indicates the pixel to be encoded. In the simplest case of binary encoding, the value at each location, a,b, c, etc., is either '0' or '1'. A context template is formed by considering the values of selected locations. For reasons of simplicity, the context template in this illustration comprises only the shaded locations, namely locations 'c' and 'g' (shaded grey).

A 'context' in this example is a single permutation of the values in the locations of the context template. Considering all possible permutations, we obtain the following table:

|  | c | g |
| --- | --- | --- |
| Context 1 | 0 | 0 |
| Context 2 | 0 | 1 |
| Context 3 | 1 | 0 |
| Context 4 | 1 | 1 |

The context selection technique shown in Figure 3 is intrinsically bound to the subsequent Golomb Code stage. For each context we measure the frequency of X='0' and X='1'. Based on this measured frequency we estimate the parameter m of the Golomb-Code. The goal is to select contexts such that the measured frequency of '0' for each context gets closest to the probability model for which the Golomb code of order m is optimal.

By contrast the conventional context selection stage of Figure 2B operates to maximise the probability of finding X='0' (or '1').

In the embodiment illustrated in Figure 3, the analytical entropy coder 314 makes use of Golomb codes (GC). After entropy coding has been performed the signals are streamed in a single bitstream.

In further embodiments of the invention, the source of the symbol stream upon which first the run length processor and then the analytical entropy coder operate need not be limited to the specific stages illustrated in Figure 3. The symbol stream can be provided as the results of scanning any binary map or can be the result from slicing coefficients into bitplanes followed by applying appropriately designed context. The described symbol stream is based on transform coefficients but can be extended to data of any type, including: discrete cosine, integer cosine transform (ICT), finite Fourier, or wavelet transform coefficients; image intensity values; or even two or three dimensional administration information, MPEG-4 descriptors for example.

The approach described above can be generalised to any kind of two-dimensional plane or three-dimensional array of binary or even non-binary symbols. A coded block pattern (CBP) can be encoded with this technique.

The separate processes performed by the processors shall now be explained in greater detail.

In the irrelevance reduction processor (the bitplane slicer), the transform coefficients $G$ [] are sliced into $N$ bitplanes, $\alpha_k$[]:

$$G[i, j] = \sum_k \alpha_k[i, j] 2^k, \quad \alpha \in \{0, 1\}$$

where k ∈ {0, ... ,$N$ - 1}.

Each bitplane can be considered as a binary array or map

$$\mathcal{M}_k = \{\alpha_k[i,j] | (i,j) \in \Lambda\},$$

where $\Lambda$ is a 2D grid.

In the following step, the context selection processor operates on each bitplane and statistical dependencies between neighbouring pixels are exploited by forming contexts $C_l$. Let $S_p$ denote one particular binary pattern formed by the pixel values in the neighbourhood $\mathcal{N}$ of $b[i,j]$

$$\mathcal{S}_p = \{b[i-n, j-m]\} | (m,n) \in \mathcal{N}\}$$

As the number of patterns $S_p$ can get very large, depending on the number of elements of the neighbourhood, a context $C_l$ is defined as a set containing at least one pattern $S_p$. The context must be causal with respect to the scan order for continuous decodability, which restricts the elements in the neighbourhood $\mathcal{N}$. Moreover, the context can even be extended to three dimensions by incorporating pixels in neighbouring higher order bitplanes. Associated with each context $C_k$ is a bit buffer $\mathcal{B}_k$ that is operable to store the binary values identified as "belonging" to context $C_k$.

The context $C_k$ is defined in order to maximise the probability of one of the two possible binary symbols, '0' and '1', with respect to this context. In other words, the context selection seeks to exploit statistical dependencies between neighbouring symbols. Context selection thus increases the probability of a correct prediction of the current pixel value. As a consequence, the generated bitstream for each context shows a high probability for one symbol. Furthermore, depending on the contexts defined, the resulting sequences of each context are almost completely statistically independent.

When entropy encoding such context selected sequences, arithmetic coding takes advantage of the presence of those symbols which have high probabilities of occurrence and which have a (theoretical) code word lengths of less than one bit.

According to the present invention, a run-length pre-coder is applied to the context selected binary sequence. The run-length symbols are then input into a GC function to generate an output bitstream. A great advantage of this embodiment is that run-length symbols obtained from a binary sequence of statistically independent binary symbols always show an (exponentially decaying) geometric distribution:

$$pdf(i) = p^i (1 - p),$$

where p < 1,

regardless of the underlying distribution of the transform coefficients, where p is the probability of the symbol '0' and $i$ the length of run of consecutive '0's. It has been shown that GCs are optimal for geometrically distributed sources. This embodiment therefore allows the encoding of binary maps to approach the theoretical optimum.

Advantageously, GCs allow a very simple adaption to varying symbols statistics: a different code order m is employed depending on the probability, p.

Whilst they have been know since the 1970's, GCs appear in only a small number of applications: one known application is in the JPEG 2000 standard.

GCs are prefix-free codes and can therefore be treated in a similar fashion to VLCs, offering the same advantages as these codes. Moreover, the approach offers high coding efficiency exceeding the performance of arithmetic coding because the distribution of the source data matches the distribution of the code very well.

Finally, code conforming to the present invention has great advantages in terms of implementation. As there is no need to store any tables, the codes are very easy to generate, the codes are simple to decode and the codes can be adapted to varying symbol statistics by just changing the order of the code (a single number).

**Claims**

1. A method of encoding source data comprising the steps of:

   decorrelating (302) source data to generate transform coefficient information;
   slicing (304) said transform coefficient information into a plurality of bitplanes ($M_k$), said plurality of bitplanes including one least significant bitplane;

context selecting (308) on each bitplane by exploiting the statistical dependencies between neighbouring pixels to generate a plurality of selected context patterns ($S_p$) wherein each selected context pattern is selected by establishing which of available context patterns best matches the probability model for which a Golomb Code (GC) is optimal;

for at least some of the plurality of the selected context patterns, applying run-length pre-coding (312) to generate sequences of pre-coded symbols and then encoding said pre-coded symbol sequences by an analytical entropy coding scheme (314), said scheme being a Golomb coding scheme.

2. A method according to Claim 1, wherein the symbol sequences are binary symbol sequences.

3. A method according to Claim 1 or 2, wherein the bitplane slicing is performed by the Zero-tree approach.

4. A method according to any one of Claims 1 to 3, wherein the context selection stage includes the steps of:

measuring the frequency of a given symbol (0; 1) from among the symbols representing pixels in a bitplane for each of a plurality of context patterns;
generating a probability model; and
comparing the measured frequency of the given symbol for each of the plurality of context patterns with the probability model.

5. A method according to claim 4, wherein the given symbol is a zero.

6. A data encoding apparatus comprising:

a redundancy reduction processor (302) for generating transform coefficient information,
a relevant data reduction processor (304) for slicing said fransform coefficient information into a plurality of bitplanes,
a context selection processor (308); and
an entropy encoding processor (310);

wherein the context selection processor (308) generates for said plurality of bitplanes a respective plurality of context data output streams, said context selection being based on exploiting the statistical dependencies between neighbouring pixels, to generate a plurality of selected context patterns, wherein each selected context pattern is selected by establishing which of available context patterns best matches the probability model for which a Golomb Code is optimal; and wherein

at least some of the plurality of context data output streams is input into said entropy encoding processor (310) comprising a run-length pre-coder (312) for generating sequences of pre-coded symbols, followed by an analytical entropy coding processor (314) using a Golomb coding scheme for coding the pre-coded symbol sequences.

**Patentansprüche**

1. Verfahren zur Codierung von Quelldaten, welches die folgenden Schritte umfasst:

Dekorrelieren (302) der Quelldaten, um Transformationskoeffizienten-Informationen zu erzeugen;
Zerlegen (304) der besagten Transformationskoeffizienten-Informationen in eine Vielzahl von Bitebenen ($M_k$), wobei die besagte Vielzahl von Bitebenen eine am wenigsten signifikante Bitebene enthält;
Wählen von Kontext (308) auf jeder Bitebene durch Ausnutzung der statistischen Abhängigkeiten zwischen benachbarten Pixeln, um eine Vielzahl von ausgewählten Kontextmustern ($S_p$) zu erzeugen, wobei jedes ausgewählte Kontextmuster gewählt wird, indem festgestellt wird, welches von verfügbaren Kontextmustern am besten zu dem Wahrscheinlichkeitsmodell passt, für welches ein Golomb-Code (GC) optimal ist;
für wenigstens einige Kontextmuster aus der Vielzahl der ausgewählten Kontextmuster Anwenden von Lauflängen-Vorcodierung (312), um Folgen von vorcodierten Symbolen zu erzeugen, und anschließend Codieren der besagten vorcodierten Symbolfolgen mittels eines analytischen Entropiecodierungs-Schemas (314), wobei das besagte Schema ein Golomb-Codierungsschema ist.

2. Verfahren nach Anspruch 1, wobei die Symbolfolgen binäre Symbolfolgen sind.

3. Verfahren nach Anspruch 1 oder 2, wobei das Zerlegen in Bitebenen mittels der Zero-Tree-Technik durchgeführt wird.

4. Verfahren nach einem der Ansprüche 1 bis 3, wobei der Schritt der Kontextwahl die folgenden Teilschritte beinhaltet:

Messen der Häufigkeit eines gegebenen Symbols (0; 1) aus der Menge der Symbole, welche Pixel in einer Bitebene darstellen, für jedes Kontextmuster aus einer Vielzahl von Kontextmustern;
Erzeugen eines Wahrscheinlichkeitsmodells; und
Vergleichen der gemessenen Häufigkeit des gegebenen Symbols für jedes der Kontextmuster aus der Vielzahl von Kontextmustern mit dem Wahrscheinlichkeitsmodell.

5. Verfahren nach Anspruch 4, wobei das gegebene Symbol eine Null ist.

6. Datencodierungs-Vorrichtung, welche umfasst:

einen Redundanzminderungs-Prozessor (302) zum Erzeugen von Transformationskoeffizienten-Informationen;
einen Prozessor zur Reduktion irrelevanter Daten (304) zum Zerlegen der besagten Transformationskoeffizienten-Informationen in eine Vielzahl von Bitebenen;
einen Kontextwahl-Prozessor (308); und
einen Entropiecodierungs-Prozessor (310);

wobei der Kontextwahl-Prozessor (308) für die besagte Vielzahl von Bitebenen eine jeweilige Vielzahl von Kontextdaten-Ausgangsströmen erzeugt, wobei die besagte Kontextwahl auf der Ausnutzung der statistischen Abhängigkeiten zwischen benachbarten Pixeln beruht, um eine Vielzahl von ausgewählten Kontextmustern zu erzeugen, wobei jedes ausgewählte Kontextmuster gewählt wird, indem festgestellt wird, welches von verfügbaren Kontextmustern am besten zu dem Wahrscheinlichkeitsmodell passt, für welches ein Golomb-Code optimal ist; und wobei
wenigstens einige Kontextdaten-Ausgangsströme aus der Vielzahl von Kontextdaten-Ausgangsströmen in den besagten Entropiecodierungs-Prozessor (310) eingegeben werden, der einen Lauflängenvorcodierer (312) zur Erzeugung von Folgen von vorcodierten Symbolen umfasst, gefolgt von einem analytischen Entropiecodierungs-Prozessor (314), der ein Golomb-Codierungsschema zum Codieren der Folgen von vorcodierten Symbolen verwendet.

## Revendications

1. Procédé de codage de données sources comprenant les étapes consistant à :

décorréler (302) des données sources pour générer des informations de coefficients de transformation;
trancher (304) lesdites informations de coefficients de transformation en une pluralité de plans binaires ($M_k$), ladite pluralité de plans binaires comprenant un plan binaire de poids faible;
sélectionner le contexte (308) sur chaque plan binaire en exploitant les dépendances statistiques entre des pixels voisins pour générer une pluralité de motifs de contexte sélectionnés ($S_p$), où chaque motif de contexte sélectionné est sélectionné en établissant lequel des motifs de contexte disponibles concorde le mieux avec le modèle de probabilité pour lequel un code de Golomb (GC) est optimal;
pour au moins certains de la pluralité de motifs de contexte sélectionnés, appliquer un précodage par longueur de plage (312) pour générer des séquences de symboles précodés et coder ensuite lesdites séquences de symboles précodés par un code entropique analytique (314), ledit code étant un code de Golomb.

2. Procédé selon la revendication 1, dans lequel les séquences de symboles sont des séquences de symboles binaires.

3. Procédé selon la revendication 1 ou 2, dans lequel la mise en tranche en plans binaires est exécutée par l'approche à arbres de zéros.

4. Procédé selon l'une quelconque des revendications 1 à 3, dans lequel l'étage de sélection de contexte comprend les étapes consistant à :

mesurer la fréquence d'un symbole donné (0; 1) parmi les symboles représentant les pixels dans un plan binaire, pour chacun d'une pluralité de motifs de contexte;
générer un modèle de probabilité; et
comparer la fréquence mesurée du symbole donné pour chacun de la pluralité de motifs de contexte au modèle de probabilité.

5. Procédé selon la revendication 4, dans lequel le symbole donné est un zéro.

6. Dispositif de codage de données comprenant :

un processeur de réduction de redondance (302) pour générer des informations de coefficients de transformation,
un processeur de réduction de données pertinentes (304) pour trancher lesdites informations de coefficients de transformation en une pluralité de plans binaires,
un processeur de sélection de contexte (308); et
un processeur de codage entropique (310);

dans lequel le processeur de sélection de contexte (308) génère, pour ladite pluralité de plans binaires, une pluralité respective de trains de sortie de données de contexte, ladite sélection de contexte étant basée sur l'exploitation des dépendances statistiques entre des pixels voisins, pour générer une pluralité de motifs de contexte sélectionnés, où chaque motif de contexte sélectionné est sélectionné en établissant lequel des motifs de contexte disponibles concorde le mieux au modèle de probabilité pour lequel un code de Golomb est optimal; et dans lequel au moins certains de la pluralité de trains de sortie de données de contexte sont délivrés en entrée dans ledit processeur de codage entropique (310) comprenant un précodeur par longueur de plage (312) pour générer des séquences de symboles précodés, suivi par un processeur de codage entropique analytique (314) utilisant un code de Golomb pour coder les séquences de symboles précodés.

## FIG 1

Pixel Value → **DCT** → coefficient → **Quant** → level → **Run-Length Coding** → RL-symbol → **VCL** → bitstream

Redundance-Reduction

Irrelevance and relevance reduction

Statistical dependencies

Entropy-Coding

FIG 2A

Pixel Value → DCT → coefficient → Bitplane slicing → Run-length → Run-Length coding → bitstream

Redundance-Reduction | Irrelevance-Reduction | Statistical dependencies

VLC coding

FIG 2B

Pixel Value → DCT/ ICT → coefficient → Bitplane slicing → level → context selection → context → (adapt.) arithmetic coding / (adapt.) arithmetic coding → bitstream

level

Redundance-Reduction

As transform, any linear transform may be applied

Irrelevance-Reduction (if not all bitplanes are coded)

Statistical dependencies

Entropy-Coding

FIG 3